# EUROPÄISCHE PATENTSCHRIFT

(11) **EP 2 282 914 B1**
(45) Veröffentlichungstag und Bekanntmachung des Hinweises auf die Patenterteilung: **09.09.2015**
(21) Anmeldenummer: 09757347.1
(22) Anmeldetag: 06.04.2009
(51) Int. Cl.: B60R 21/01, G01D 18/00, G01P 1/02, H05K 5/00

(54) **STEUERGERÄT FÜR PERSONENSCHUTZMITTEL FÜR EIN FAHRZEUG UND VERFAHREN ZUM ZUSAMMENBAU EINES STEUERGERÄTS FÜR PERSONENSCHUTZMITTEL FÜR EIN FAHRZEUG**
CONTROL DEVICE FOR PASSENGER PROTECTION MEANS FOR A VEHICLE AND METHOD FOR ASSEMBLING A CONTROL DEVICE FOR PASSENGER PROTECTION MEANS FOR A VEHICLE
APPAREIL DE COMMANDE D'UN MOYEN DE PROTECTION DE PERSONNES POUR UN VEHICULE ET PROCEDE D'ASSEMBLAGE D'UN APPAREIL DE COMMANDE D'UN MOYEN DE PROTECTION DE PERSONNES POUR UN VEHICULE

(30) Priorität: 02.06.2008 DE 102008002160
(43) Veröffentlichungstag der Anmeldung: 16.02.2011
(73) Patentinhaber: Robert Bosch GmbH, 70442 Stuttgart (DE)
(72) Erfinder: MOSER, Manfred, 72768 Reutlingen (DE); WONNER, Mark, 71706 Marbach Am Neckar (DE); CUPAL, Roland, 71706 Markgroeningen (DE)
(86) Internationale Anmeldenummer: PCT/EP2009/054064
(87) Internationale Veröffentlichungsnummer: WO 2009/146964

(56) Entgegenhaltungen:
- EP-A- 1 443 331
- EP-A- 1 538 030
- WO-A-2006/005769
- DE-U1- 20 112 595

## Beschreibung

### Stand der Technik

Die Erfindung betrifft ein Steuergerät für Personenschutzmittel für ein Fahrzeug bzw. ein entsprechendes Verfahren zum Zusammenbau eines solchen Steuergeräts nach der Gattung der unabhängigen Patentansprüche.

Aus EP 0 927 508 B1 ist ein Airbagsteuergerät bekannt, das eine Leiterplatte aufweist für die Aufnahme von diversen elektronischen Bauteilen, wobei die Leiterplatte von einem Deckel versehenen Gehäuse umschlossen ist. Zur Befestigung des Gehäuses am Kraftfahrzeug weist der Gehäusedeckel Befestigungslaschen oder Flansche auf, über die außerdem die Orientierung des Steuergeräts festgelegt wird. Diese feste Orientierung des Steuergeräts ist zwingend, da der üblicherweise verwendete Beschleunigungssensor eine vorgegebene Empfindlichkeitsrichtung hat. Die Leiterplatte wird im Gehäuse mittels Schrauben befestigt.

Aus der EP 1443 331 A2 ist bekannt, eine Sensorik, mit einem Beschleunigungssensor, der elektrische Signale in Abhängigkeit von der physischen Beeinflussung seiner Erfassungseinheit erzeugt und einem Gehäuse, das diesen Beschleunigungssensor aufnimmt. Eine Gehäusekammer ist mit einem Dichtungsmaterial verschlossen, so dass der Beschleunigungssensor vollständig von dem Dichtungsmaterial bedeckt ist. Das Dichtungsmaterial hat die Aufgabe zuverlässig hochfrequente Vibrationen, die Resonanzen erzeugen, zu dämpfen. Damit der Beschleunigungssensor exakt Kollisionen und Vibrationen detektieren kann ohne negativ durch Resonanzen beeinflusst zu werden.

Aus der DE 20112 595 U1 ist bekannt, ein Gehäuse zur Aufnahme mindestens einer Leiterplatte mit elektronischen Bauteilen, bestehend aus einer allgemein quaderförmigen Haube aus Kunststoff, die an einer ihrer Schmalseiten einen Steckerkragen aufweist, und einer die Haube verschließenden Bodenplatte, wobei, die Leiterplatte an wenigstens drei der vier Ecken der Haube mit metallischen Montagebuchsen mechanisch und elektrisch leitend verbunden ist, die Haube an diesen Ecken je einen Montageflansch aufweist und die Montagebuchse in den Montageflansch der Haube verankert ist.

### Offenbarung der Erfindung

Das erfindungsgemäße Steuergerät für Personenschutzmittel für ein Fahrzeug bzw. das erfindungsgemäße Verfahren zum Zusammenbau eines Steuergeräts für Personenschutzmittel für ein Fahrzeug mit den Merkmalen der unabhängigen Patentansprüchen haben demgegenüber den Vorteil, dass mit dem Zusammenbau des Steuergeräts auch die Leiterplatte befestigt wird und insbesondere die entsprechenden Verbindungsmittel auch dafür dienen, das Steuergerät am Kraftfahrzeug zu befestigen. Damit wird eine äußerst kostengünstige Lösung erreicht, die Arbeitsschritte einspart und dennoch zu einer robusten, kraftschlüssigen Verbindung des Gehäusedeckels des Gehäusebodens und der Leiterplatte des Steuergeräts mit der Fahrzeugkarossserie führt.

Besonders vorteilhaft ist dabei, dass höchstens drei Verbindungsmittel für den kraftschlüssigen Zusammenbau des Kunststoffdeckels des Kunststoffbodens und der wenigstens einen Leiterplatte verwendet werden. Vorzugsweise sollen nur zwei verwendet werden, was die Kosten noch weiter reduziert.

Dadurch, dass der kraftschlüssige Zusammenbau am Fahrzeug erfolgt, ist es möglich, eine Vorfixierung des Kunststoffdeckels des Kunststoffbodens und der Leiterplatte vorzusehen. Diese Vorfixierung kann mit weiteren Verbindungsmitteln erreicht werden, die einfacher gestaltet sind, als die höchstens drei Verbindungsmittel die zum kraftschlüssigen Zusammenbau und zur Verbindung mit der Fahrzeugkarosserie dienen. Beispiele hierfür sind Clips usw. Es ist jedoch auch eine Vorfixierung mit den höchstens drei Verbindungsmitteln möglich.

Durch das so erreichte Zweipunkt- oder Dreipunkt-Fixierkonzept wird eine Sicherstellung einer Sensorfunktionalität im Steuergerät für Personenschutzmittel ermöglicht. Dadurch, dass die wenigstens eine Leiterplatte direkt über die Verbindungsmittel mit Gehäuse und Boden angebunden wird, wird ein Übertragen von Schwingungen und Resonanzen oder negativem Einfluss der Mechanikkomponenten ermöglicht. Die Lösung gemäß dem Stand der Technik, zunächst die Leiterplatte im Airbagsteuergerät einzuschrauben, kann einen Verbund von Resonanzen nach Verbau im Fahrzeug mit sich bringen. Diese Resonanzen können sich negativ auf die Übertragungsfunktion auswirken, wobei die Übertragungsfunktion die Übertragung von Verzögerungen von der Fahrzeugkarosserie auf die Leiterplatte und damit auf den Beschleunigungssensor beschreibt. Erfindungsgemäß wird der endgültige Verbund mit den Verbindungsmitteln im Fahrzeug realisiert. Dadurch ist eine direkte Anbindung der wenigstens einen Leiterplatte ans Fahrzeug gewährleistet. Resonanzen, erzeugt durch Mechanikbauteile können so keinen erheblichen Einfluss auf die Leiterplatte ausüben.

Vorliegend ist das Steuergerät ein elektrisches Gerät, das Sensorsignale wie Beschleunigungssignale verarbeitet und in Abhängigkeit davon Steuersignale für die Personenschutzmittel erzeugt. Als Personenschutzmittel sind aktive und passive Personenschutzmittel zu verstehen. Dazu gehören demnach passive Personenschutzmittel, wie Airbags, Gurtstraffer, crashaktive Kopfstützen oder crashaktive weitere Sitzkomponenten, aber auch Fußgängerschutzmittel und auch Bremsen und eine Fahrdynamikregelung.

Die wenigstens eine Leiterplatte ist ein Substrat mit elektrischen Verbindungen auf dem elektrisch und auch elektronische Bauteile aufgebracht sind, wobei die elektrischen Verbindungen diese elektronische und elektrischen Bauteile miteinander verbinden. Es ist dabei möglich, dass auf der wenigstens einen Leiterplatte eine Unfallsensorik, wie eine Beschleunigungssensorik oder Körperschallsensorik einer Auswerteschaltung wie ein Mikrocontroller sowie eine Ansteuerungsschaltung zur Erzeugung der Ansteuersignale vorgesehen sind. Weitere für den Betrieb des Steuergeräts erforderlichen Bauteile können auf dieser Leiterplatte befestigt sein. Die Befestigung erfolgt üblicher Weise durch Löt- oder Klebe- oder Einpressprozesse. Auch eine Klemmverbindung ist möglich. Damit sind sowohl stoffflüssige als auch haftschlüssige Verbindungen der elektrischen Bauteile auf der Leiterplatte möglich. Die Leiterplatte kann aus einem Kunststoff, einer Keramik oder anderen geeigneten isolierenden Materialien ausgeführt sein, wobei Metallisierungen üblicherweise als elektrische Verbindungen zwischen den Bauelementen dienen. Es sind jedoch auch andere Stoffe möglich, die elektrische Verbindungen ermöglichen.

Erfindungsgemäß ist ein Kunststoffdeckel und ein Kunststoffboden vorgesehen, die die Leiterplatte umschließen, so dass die wenigstens eine Leiterplatte zwischen dem Kunststoffdeckel und dem Kunststoffboden angeordnet ist. Dabei können folgende Materialien verwendet werden: PBT-GF30 und PA66 GF30. Gegebenenfalls kann eine Beimischung für die Verbesserung von elektrischen Abschirmungseigenschaften vorgesehen sein, also eine bessere elektromagnetische Verträglichkeit.

Als höchstens drei Verbindungsmittel sind, bspw. wie es aus den abhängigen Ansprüchen hervorgeht Schrauben aber auch Nieten, Klemmen oder andere kraftschlüssige Verbindungsmittel möglich z.B. auch Muttern über Stehbolzen. Üblicherweise müssen die höchstens drei Verbindungsmittel für die kraftschlüssige Verbindung mit der Fahrzeugkarosserie über den Gehäuseboden bzw. Gehäusedeckel hinausragen, um mit der Fahrzeugkarosserie in Verbindung zu treten.

Als Zusammenbau wird vorliegende die kraftschlüssige Verbindung des Kunststoffdeckels des Kunststoffbodens und der wenigstens einen Leiterplatte mit den höchstens zwei Verbindungsmitteln gesehen.

Durch die in den abhängigen Ansprüchen aufgeführten Maßnahmen und Weiterbildungen sind vorteilhafte Verbesserungen des in den unabhängigen Patentansprüchen angegebenen Steuergeräts bzw. Verfahrens zum Zusammenbau des Steuergeräts für Personenschutzmittel für ein Fahrzeug möglich.

Dabei ist es vorteilhaft, dass die höchstens drei Verbindungsmittel als Schrauben ausgebildet sind. Dabei können die unterschiedlichsten Typen von Schrauben angewendet werden. Die Schraubverbindungen sind zuverlässig und können kostengünstig hergestellt werden.

Darüber hinaus ist es vorteilhaft, dass für die höchstens drei Verbindungsmittel jeweils Buchsen im Kunststoffdeckel und dem Kunststoffboden vorgesehen sind: Das bedeutet, dass die Buchsen für ein Verbindungsmittel wie eine Schraube sowohl im Kunststoffdeckel als auch im Kunststoffboden vorgesehen sind. Die Gewinde befinden sich dann unter dem Steuergerät in der Fahrzeugkarosserie. Auch in den Buchsen können Gewinde vorgesehen sein. Damit ist eine zuverlässige, kraftschlüssige Schraubverbindung möglich. Das heißt pro Verbindungsmittel sind zwei Buchsen vorgesehen. Die Buchsen können auf verschiedenste Art und Weise in den Kunststoffdeckel bzw. den Kunststoffboden eingebracht werden. Eine besondere Variante ist dabei das Einpressen oder dass Umspritzen im Kunststoff. Eine vorteilhafte Variante ist das Umspritzen im Kunststoffdeckel und das Einpressen im Kunststoffboden.

Dabei ist möglich, dass die Buchse über den Gehäuseboden hinausragt. Aufgrund von Verzug und Toleranzen der Kunststoffteile muss die jeweilige Buchse, die zumindest teilweise leitend und daher vorzugsweise metallisch ist, leicht überstehen, damit die Masseanbindung gewährleistet werden kann. Dies ergibt eine flächige Auflage, der Buchse auf der Fahrzeuggeometrie.

Vorteilhafter Weise hat die Leiterplatte eine elektrische Verbindung über wenigstens eines der höchstens drei Verbindungsmittel. Dies bedeutet bei der Verwendung von metallischen Schrauben als Verbindungsmittel, dass über diese Verbindungsmittel die Leiterplatte an die Fahrzeugkarosserie elektrisch angeschlossen ist und somit eine gute Masseanbindung aufweist. Durch das "Sandwich" Buchse Gehäuse, Leiterplatte und Buchse Boden, der durch die Verschraubung realisiert wird, ist die Leiterplatte elektrisch an der Fahrzeuggeometrie (Masseanbindung) angebunden.

Ausführungsbeispiele der Erfindung sind in der Zeichnung dargestellt und werden in der nachfolgenden Beschreibung näher erläutert.

Es zeigen Figur 1 eine schematische Schnittdarstellung des erfindungsgemäßen Steuergeräts, Figur 2 ein Detail dieses Schnitts und Figur 3 ein Flussdiagramm des erfindungsgemäßen Verfahrens.

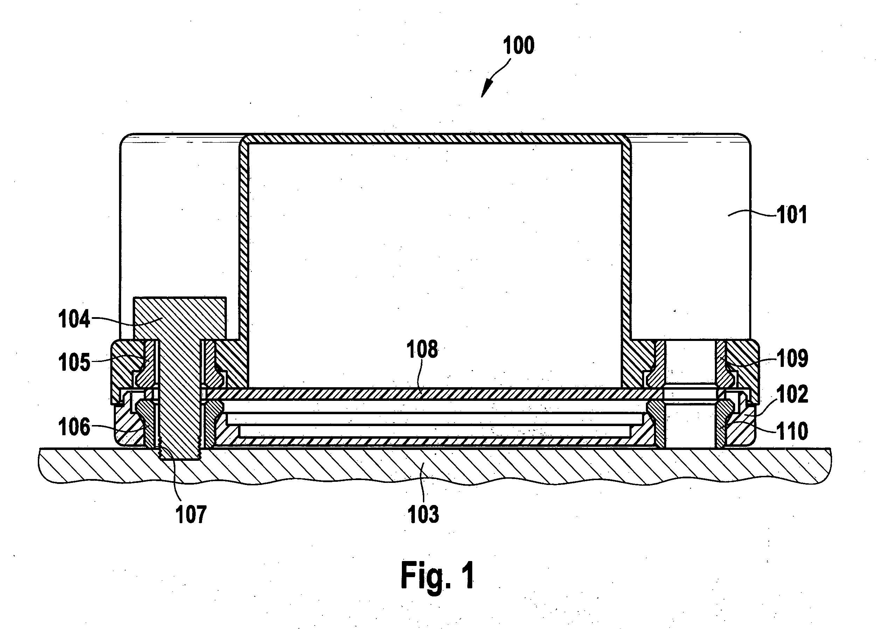

Figur 1 zeigt in einer Schnittdarstellung das erfindungsgemäße Steuergerät 100 im zusammengebauten und mit der Fahrzeugkarosserie 103 verbundenen Zustand. Vorliegend ist das Steuergerät 100 über zwei Buchsenpaare 105, 106, 109 und 110 kraftschlüssig über Schrauben 104 miteinander verbunden und an die Fahrzeugkarosserie 103 angeschlossen. Dafür weist die Fahrzeugkarosserie auch entsprechende Gewinde auf. Diese können beispielsweise auch eingepresst sein. Vorliegend wird beispielhaft lediglich eine Schraube 104 dargestellt.

Die Schraube 104 wird in die Buchse 105 im Kunststoffdeckel 101 durch eine Bohrung in der Leiterplatte 108 in eine weitere Buchse 106 des Kunststoffbodens 102 eingeführt und dann in die Fahrzeugkarosserie im jeweiligen Gewinde eingeschraubt. Damit ist eine kraftschlüssige Verbindung des Kunststoffdeckels 101 der Leiterplatte 108 von dem Kunststoffboden 102 mit der Fahrzeugkarosserie 103 hergestellt. Darüber hinaus kann entweder über die Buchsen 106 und/oder die Schraube 104 eine elektrische Verbindung der Leiterplatte 108 zur Fahrzeugskarosserie 103 und damit eine Masseverbindung hergestellt werden. Die Masseanbindung der Leiterplatte 108 kann auch durch einen minimalen Überstand 107 der Buchse erfolgen. Die entsprechende Verbindung wird am anderen Buchsenpaar 109 und 110 durchgeführt, um zwei Verbindungsmittel vorliegend lediglich zu verwenden.

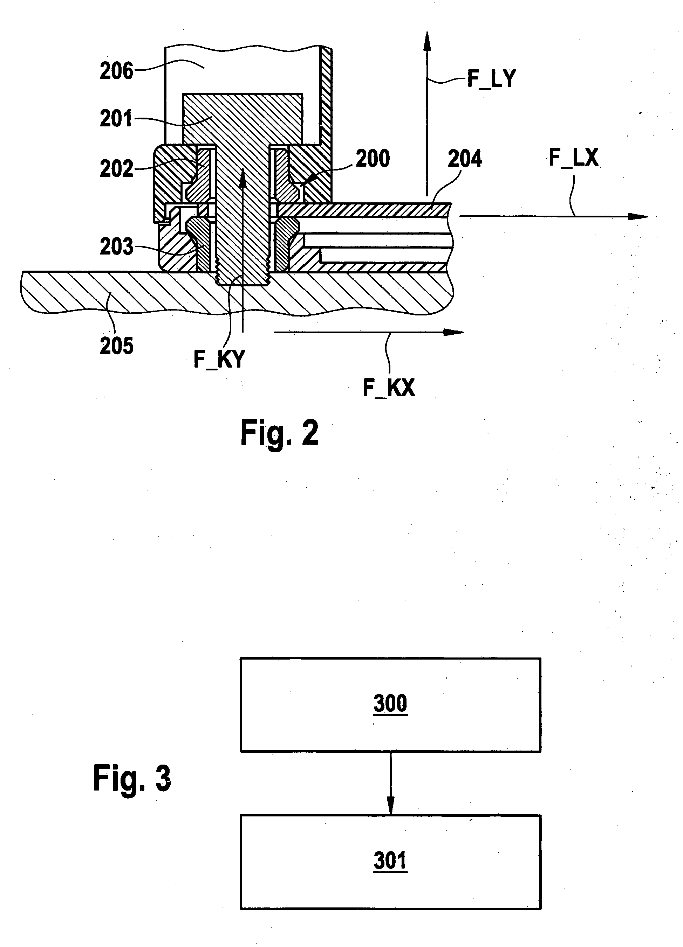

Figur 2 zeigt die Schraubverbindung 200 der Schraube 201 und die entsprechenden Kraftwirkungen auf die Fahrzeugkarosserie, sowie auf die Leiterplatte im Detail. Wiederum verbindet die Schraube 201 den Gehäusedeckel 206, die Leiterplatte 204 und den Kunststoffboden mit der Fahrzeugkarosserie 205. Dafür wird die Schraube durch die Buchsen 202 im Kunststoffdeckel 206 und durch die Buchse 203 im Kunststoffboden durchgesteckt und in die Fahrzeugskarosserie eingeschraubt. Wie in Figur 2 dargestellt, werden die Kraftwirkungen in Fahrzeugvertikalrichtung F_KY und Fahrzeuglängsrichtung F_KX in der Fahrzeugkarosserie über diese kraftschlüssige Verbindung auf die Leiterplatte übertragen, so dass sich entsprechend die Fahrzeugvertikalbeschleunigung F_LY und Fahrzeuglängsbeschleunigung F_LX ergeben, die sich dann aneinander entsprechen. Dies gilt auch für die Fahrzeugquerbeschleunigung die in die Zeichnungsebene hineingeht.

Figur 3 zeigt ein Flussdiagramm des erfindungsgemäßen Verfahrens zum Zusammenbau des erfindungsgemäßen Steuergeräts. In Verfahrensschritt 300 erfolgt das Vorfixieren des Kunststoffdeckels der wenigstens einen Leiterplatte und des Kunststoffbodens um dann das so vorfixierte Steuergerät in Verfahrensschritt 301 miteinander zu verbinden und zwar mit höchstens drei Verbindungsmittel, wobei auch eine kraftschlüssige Verbindung dann mit der Fahrzeugkarosserie vorgesehen ist.

## Patentansprüche

1. Steuergerät (100) für Personenschutzmittel für ein Fahrzeug mit:
- wenigstens einer Leiterplatte (108, 204) für eine Aufnahme von elektrischen Bauelementen
- einem Kunststoffdeckel (101, 206) und einem Kunststoffboden (102), zwischen denen die wenigstens eine Leiterplatte (108, 204) angeordnet ist.
- höchstens drei Verbindungsmitteln (104, 201), die den Kunststoffdeckel (101, 206) den Kunststoffboden (102) und die wenigstens eine Leiterplatte (108, 204) direkt miteinander verbinden, wobei die Verbindungsmittel zusätzlich für eine kraftschlüssige Verbindung mit der Fahrzeugkarosserie (103, 205) vorgesehen sind.

2. Steuergerät nach Anspruch 1, **dadurch gekennzeichnet, dass** die höchstens drei Verbindungsmittel (104, 201) als Schrauben ausgebildet sind.

3. Steuergerät nach Anspruch 1 oder 2, **dadurch gekennzeichnet, dass** für die höchstens drei Verbindungsmittel (104, 201) jeweils Buchsen (105, 106, 109, 110, 202, 203) jeweils in dem Kunststoffdeckel (101, 206) und den Kunststoffboden (102) eingepresst sind.

4. Steuergerät nach Anspruch 3, **dadurch gekennzeichnet, dass** die Buchsen jeweils in den Kunststoffdeckel (101, 206) und den Kunststoffboden (102) eingepresst sind.

5. Steuergerät nach einem der vorhergehenden Ansprüche, **dadurch gekennzeichnet, dass** die wenigstens eine Leiterplatte (108, 204) eine elektrische Verbindung zu wenigstens einer der höchstens drei Verbindungsmittel (104, 201) aufweist.

6. Verfahren zum Zusammenbau eines Steuergeräts (100) für ein Fahrzeug mit folgenden Verfahrensschritten: Verbinden, wenigstens einer Leiterplatte (108, 204) für eine Aufnahme von elektrischen Bauelementen, einem Kunststoffdeckel (101, 206) und einem Kunststoffboden (102) mit höchstens drei Verbindungsmitteln (104, 201) direct; wobei die wenigstens eine Leiterplatte (108, 204) zwischen dem Kunststoffdeckel (101, 206) und dem Kunststoffboden (102) angeordnet ist, wobei die höchstens drei Verbindungsmittel (104, 201) zusätzlich für eine kraftschlüssige Verbindung mit der Fahrzeugkarosserie (103, 205) vorgesehen sind.

7. Verfahren nach Anspruch 6, **dadurch gekennzeichnet, dass** als die höchstens drei Verbindungsmittel (104, 201) Schrauben oder Muttern über Gewindebolzen verwendet werden.

8. Verfahren nach Anspruch 6 oder 7 durch gekennzeichnet, dass für die höchstens drei Verbindungsmittel (104, 201) jeweils Buchsen (105, 106, 109, 110, 202, 203) im Kunststoffdeckel (101, 206) und im Kunststoffboden (102) eingebaut werden.

9. Verfahren nach Anspruch 8, **dadurch gekennzeichnet, dass** die Buchsen jeweils in den Kunststoffdeckel und den Kunststoffboden eingepresst und/oder im Kunststoff umspritzt werden.

10. Verfahren nach einem der Ansprüche 6 bis 9, **dadurch gekennzeichnet, dass** durch die Verbindung zwischen dem Kunststoffdeckel (101, 206), dem Kunststoffboden (102) und der wenigstens einen Leiterplatte (108, 204) durch die höchstens drei Verbindungsmittel (104, 201) eine elektrische Verbindung zwischen der wenigstens einen Leiterplatte (108, 204) und wenigstens einer der höchstens drei Verbindungsmittel (104, 201) hergestellt wird.

## Claims

1. Controller (100) for passenger protection means for a vehicle, comprising:
- at least one printed circuit board (108, 204) for receiving electrical components,
- a plastic cover (101, 206) and a plastic base (102) between which the at least one printed circuit board (108, 204) is arranged,
- at most three connecting means (104, 201) which connect the plastic cover (101, 206), the plastic base (102) and the at least one printed circuit board (108, 204) directly to one another, wherein the connecting means are additionally provided for a force-fitting connection to the vehicle body (103, 205).

2. Controller according to Claim 1, **characterized in that** the at most three connecting means (104, 201) are in the form of screws.

3. Controller according to Claim 1 or 2, **characterized in that** bushes (105, 106, 109, 110, 202, 203) are in each case pressed into the plastic cover (101, 206) and the plastic base (102) for each of the at most three connecting means (104, 201).

4. Controller according to Claim 3, **characterized in that** the bushes are in each case pressed into the plastic cover (101, 206) and the plastic base (102).

5. Controller according to one of the preceding claims, **characterized in that** the at least one printed circuit board (108, 204) has an electrical connection to at least one of the at most three connecting means (104, 201).

6. Method for assembling a controller (100) for a vehicle, comprising the following method steps: directly connecting at least one printed circuit board (108, 204) for receiving electrical components, a plastic cover (101, 206) and a plastic base (102) to at most three connecting means (104, 201), wherein the at least one printed circuit board (108, 204) is arranged between the plastic cover (101, 206) and the plastic base (102), wherein the at most three connecting means (104, 201) are additionally provided for a force-fitting connection to the vehicle body (103, 205).

7. Method according to Claim 6, **characterized in that** screws or nuts over threaded pins are used as the at most three connecting means (104, 201).

8. Method according to Claim 6 or 7, **characterized in that** bushes (105, 106, 109, 110, 202, 203) are incorporated in the plastic cover (101, 206) and in the plastic base (102) for each of the at most three connecting means (104, 201).

9. Method according to Claim 8, **characterized in that** the bushes are in each case pressed into the plastic cover and the plastic base and/or encapsulated in plastic by injection-moulding.

10. Method according to one of Claims 6 to 9, **characterized in that** an electrical connection is established between the at least one printed circuit board (108, 204) and at least one of the at most three connecting means (104, 201) by the connection between the plastic cover (101, 206), the plastic base (102) and the at least one printed circuit board (108, 204) by the at most three connecting means (104, 201).

## Revendications

1. Appareil de commande (100) d'un moyen de protection de personnes pour un véhicule, avec:
- au moins une plaquette de circuits imprimés (108, 204) pour la réception de composants électriques,
- un couvercle en matière plastique (101, 206) et un fond en matière plastique (102), entre lesquels ladite au moins une plaquette de circuits imprimés (108, 204) est disposée,
- au maximum trois moyens d'assemblage (104, 201), qui assemblent directement l'un à l'autre le couvercle en matière plastique (101, 206), le fond en matière plastique (102) et ladite au moins une plaquette de circuits imprimés (108, 204),
dans lequel les moyens d'assemblage sont en outre prévus pour un assemblage par adhérence avec la carrosserie du véhicule (103, 205).

2. Appareil de commande selon la revendication 1, **caractérisé en ce que** les trois moyens d'assemblage au maximum (104, 201) se présentent sous forme de vis.

3. Appareil de commande selon la revendication 1 ou 2, **caractérisé en ce que** des douilles (105, 106, 109, 110, 202, 203) sont serties respectivement dans le couvercle en matière plastique (101, 206) et dans le fond en matière plastique (102) pour chacun des trois moyens d'assemblage au maximum (104, 201).

4. Appareil de commande selon la revendication 3, **caractérisé en ce que** les douilles sont serties respectivement dans le couvercle en matière plastique (101, 206) et dans le fond en matière plastique (102).

5. Appareil de commande selon l'une quelconque des revendications précédentes, **caractérisé en ce que** ladite au moins une plaquette de circuits imprimés (108, 204) présente une liaison électrique avec au moins un des trois moyens d'assemblage au maximum (104, 201).

6. Procédé d'assemblage d'un appareil de commande (100) pour un véhicule, présentant les étapes suivantes: assembler directement au moins une plaquette de circuits imprimés (108, 204) destinée à recevoir des composants électriques à un couvercle en matière plastique (101, 206) et à un fond en matière plastique (102) avec au maximum trois moyens d'assemblage (104, 201), dans lequel ladite au moins une plaquette de circuits imprimés (108, 204) est disposée entre le couvercle en matière plastique (101, 206) et le fond en matière plastique (102), dans lequel les trois moyens d'assemblage au maximum (104, 201) sont en plus prévus pour un assemblage par adhérence avec la carrosserie du véhicule (103, 205).

7. Procédé selon la revendication 6, **caractérisé en ce que** l'on utilise des vis ou des écrous sur des tiges filetées pour les trois moyens d'assemblage au maximum (104, 201).

8. Procédé selon la revendication 6 ou 7, **caractérisé en ce que** des douilles (105, 106, 109, 110, 202, 203) sont serties respectivement dans le couvercle en matière plastique (101, 206) et dans le fond en matière plastique (102) pour chacun des trois moyens d'assemblage au maximum (104, 201).

9. Procédé selon la revendication 8, **caractérisé en ce que** les douilles sont serties respectivement dans le couvercle en matière plastique et dans le fond en matière plastique et/ou elles sont enrobées par projection dans la matière plastique.

10. Procédé selon l'une quelconque des revendications 6 à 9, **caractérisé en ce que**, par l'assemblage entre le couvercle en matière plastique (101, 206), le fond en matière plastique (102) et ladite au moins une plaquette de circuits imprimés (108, 204) au moyen des trois moyens d'assemblage au maximum (104, 201), on établit une liaison électrique entre ladite au moins une plaquette de circuits imprimés (108, 204) et au moins un des trois moyens d'assemblage au maximum (104, 201).
